# EUROPÄISCHE PATENTSCHRIFT

(11) **EP 0 595 314 B1**
(45) Veröffentlichungstag und Bekanntmachung des Hinweises auf die Patenterteilung: **03.02.1999**
(21) Anmeldenummer: 93117483.3
(22) Anmeldetag: 28.10.1993
(51) Int. Cl.: H03J 1/00

(54) **Verfahren zur Abstimmung eines Rundfunkempfängers**
Tuning method for a radio receiver
Procédé pour l'accord d'un récepteur radio

(30) Priorität: 29.10.1992 DE 4236621
(43) Veröffentlichungstag der Anmeldung: 04.05.1994
(73) Patentinhaber: BECKER GmbH, D-76307 Karlsbad (DE)
(72) Erfinder: Rupprecht, Matthias, D-75334 Straubenhardt (DE); Szipanski, Jörg, D-76307 Karlsbad (DE)
(74) Vertreter: Degwert, Hartmut, Dipl.-Phys.

(56) Entgegenhaltungen:
- EP-A- 0 333 194
- EP-A- 0 451 342
- DE-A- 3 443 859

## Beschreibung

Die Erfindung betrifft ein Verfahren zur Abstimmung eines Rundfunkempfängers, der zwei Superhet-Empfangsteile aufweist, von denen das erste die von dem eingestellten Sender empfangenen Signale für die Wiedergabe über Schallwandler aufbereitet und das zweite zumindest bei Bedarf auf verfügbare Alternativfrequenzen zu dem eingestellten Sender abgestimmt wird und die sich bei den Alternativfrequenzen ergebende Empfangsqualität bewertet.

Besonders leistungsfähige Rundfunkempfänger für mobilen Betrieb, wie Autoradios, sind mit Frequenzdiversity ausgestattet und verfügen über zwei getrennte Empfangsteile, von denen das erste als Hörempfänger und das zweite als Suchempfänger bezeichnet wird. Der Suchempfänger arbeitet zumeist im Sendersuchlauf, um den Empfangsbereich nach Alternativfrequenzen zu der Senderfrequenz, auf die der Hörempfänger gerade eingestellt ist, abzusuchen. Bei der Durchstimmung des Suchempfängers über den gesamten UKW-Empfangsbereich von 87,5 bis 108 MHz und bei einer üblichen Zwischenfrequenz von 10,7 MHz würde der Lokaloszillator des Suchempfängers unvermeidlich in den Bereich der Frequenz gelangen, auf die der Hörempfänger eingestellt ist. Durch unvermeidbare Abstrahlung und Verkopplungen innerhalb des Rundfunkempfängers würde in diesem Fall der Empfang des eingestellten Senders gestört werden. Um dies zu vermeiden, wird bei herkömmlichen Rundfunkempfängern, die mit zwei Empfangsteilen in Frequenzdiversity arbeiten, eine Zwischenfrequenz mit einem Wert von mehr als 20,5 MHz gewählt, so daß die Frequenz des Lokaloszillators stets außerhalb des Empfangsfrequenzbereichs des Hörempfängers bleibt. Da die für die Nahselektion benötigten Selektionsmittel aber nur für die genormte Zwischenfrequenz von 10,7 MHz verfügbar sind, muß mit zusätzlichem Bauteileaufwand eine weitere Frequenzumsetzung durchgeführt werden. Ein Verfahren, bei dem die Störung des Hörempfängers durch die Frequenz des Lokaloszillators des Suchempfängers vermieden wird, ist auch aus der EP-A-0 451 342 bekannt.

Vor der Abstimmung des zweiten Empfangsteils auf eine Alternativfrequenz wird bei dem erfindungsgemäßen Verfahren geprüft, ob die für diese Alternativfrequenz erforderliche Oszillatorfrequenz des zweiten Empfangsteils in ein auf die Frequenz des eingestellten Senders zentriertes Frequenzband von vorbestimmter Breite fällt, und jede in dieses Frequenzband fallende Alternativfrequenz wird bei der Abstimmung des zweiten Empfangsteils übergangen Ein derartiges Verfahren ist aus der DE-A-3 443 859 bekannt. Durch diese Maßnahme ist gewährleistet, daß der Lokaloszillator des zweiten Empfangsteils, also des Suchempfängers, niemals auf Frequenzen eingestellt wird, die im Bereich der aktuellen Empfangsfrequenz des ersten Empfangsteils, also des Hörempfängers, liegen. Durch diese einfache Maßnahme ist die Verwendung von einfachen Empfangsteilen möglich, wie sie auch oder in ähnlicher Form in Rundfunkempfängern mit nur einem Empfangsteil verwendet werden.

Der Erfindung liegt die Aufgabe zugrunde, ohne Inkaufnahme von Empfangsstörungen die Verwendung von Empfangsteilen in Einfach-Superheterodyntechnik für in Frequenzdiversity betriebene Rundfunkempfänger zu ermöglichen, und dabei keinerlei Einbußen bei der Leistungsfähigkeit der Frequenzdiversity-Funktion in Kauf nehmen zu müssen. Diese Aufgabe wird durch die zwei Varianten der Erfindung, die durch die Ansprüche 1 und 2 definiert sind, gelöst.

Gemäß der ersten Variante wird vor der Abstimmung des zweiten Empfangsteils auf eine Alternativfrequenz geprüft, ob diese Alternativfrequenz in ein auf die aktuelle Oszillatorfrequenz des ersten Empfangsteils zentriertes Frequenzband von vorbestimmter Breite fällt, und jede in dieses Frequenzband fallende Alternativfrequenz wird bei der Abstimmung des zweiten Empfangsteils übergangen oder zumindest hinsichtlich der für diese Alternativfrequenz erhaltenen Qualitätsbewertung nicht berücksichtigt. Wenn nämlich die Oszillatorfrequenz des ersten Empfangsteils, also des Hörempfängers, in den Bereich der Frequenz fällt, auf die das zweite Empfangsteil, also der Suchempfänger, momentan abgestimmt ist, so wird auch der Empfang dieses zweiten Empfangsteils gestört, so daß eine zuverlässige Bewertung der Empfangsqualität nicht möglich ist.

Gemäß der zweiten Variante des Verfahrens wird vor der Prüfung der Empfangsqualität einer Alternativfrequenz, die in ein auf die aktuelle Oszillatorfrequenz des ersten Empfangsteils zentriertes Frequenzband von vorbestimmter Breite fällt, das erste Empfangsteil zumindest vorübergehend auf eine der Alternativfrequenzen abgestimmt. Anschließend kann das zweite Empfangsteil auf die zu überprüfende Alternativfrequenz abgestimmt werden, ohne daß Empfangsstörungen zu befürchten sind.

Schließlich wird gemäß einer Weiterbildung des Verfahrens das zweite Empfangsteil, also der Suchempfänger, vorzugsweise nicht kontinuierlich im Suchlauf durchgestimmt, sondern nur auf bestimmte Alternativfrequenzen zu dem gerade am ersten Empfangsteil eingestellten Sender, die aus dem RDS-Datenstrom abgeleitet werden. Dies erlaubt eine schnelle Überprüfung aller in Frage kommenden Alternativfrequenzen, so daß prinzipiell nur eine geringe Wahrscheinlichkeit für Störungen des Hörempfängers durch den Suchempfänger besteht.

Das erfindungsgemäße Verfahren und ein zu seiner Durchführung geeigneter Rundfunkempfänger werden nun unter Bezugnahme auf die Zeichnung näher beschrieben. In der Zeichnung zeigen:
Fig. 1 ein Blockschaltbild eines zur Durchführung des Verfahrens geeigneten Rundfunkempfängers; und
Figuren 2 und 3 Diagramme, die den Abstimmbereich der beiden Empfangsteile des Rundfunkempfängers für zwei Ausführungsformen des Verfahrens zeigen.

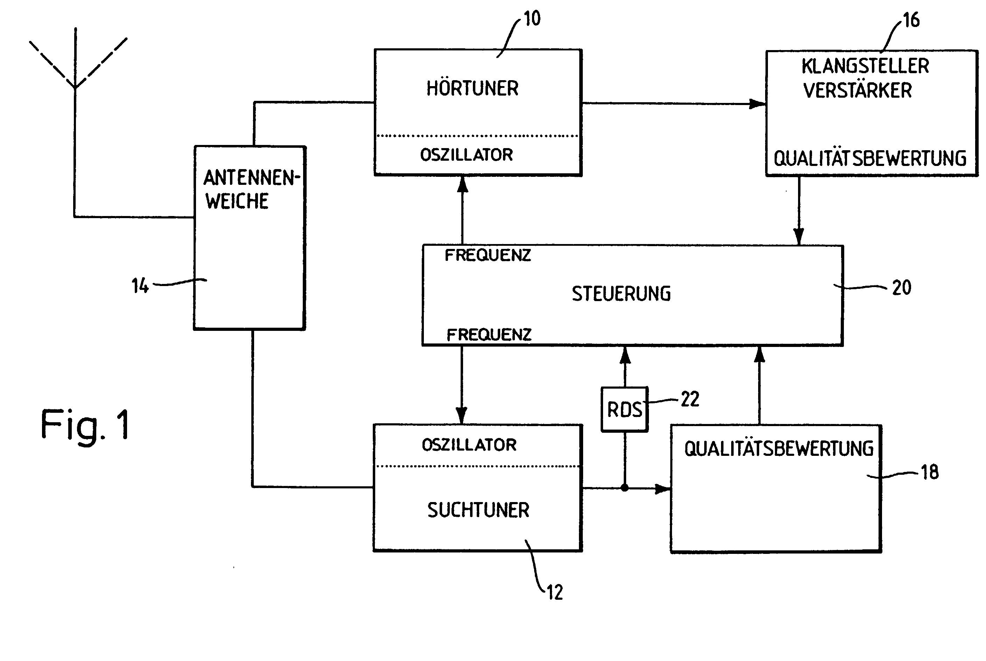

Der in Fig. 1 schematisch dargestellte Rundfunkempfänger ist ein Autoradio mit zwei Empfangsteilen, die einen Betrieb in Frequenzdiversity erlauben. Die beiden Empfangsteile 10 und 12 des Rundfunkempfängers sind an eine Antennenweiche 14 angeschlossen. Das Empfangsteil 10 bildet den Hörempfänger, dessen Ausgang an eine NF-Stufe 16 angeschlossen ist, die Filter zur Klangeinstellung, Leistungsverstärker und eine Qualitätsbewertungsschaltung beinhaltet. Das Empfangsteil 12 ist ein Suchempfänger, dessen Ausgang an eine Qualitätsbewertungsstufe 18 angeschlossen ist. Die Funktionen der beiden Empfangsteile 10, 12 werden durch eine mit einem Mikroprozessor ausgestattete Steuerschaltung 20 gesteuert. Diese Steuerschaltung 20 steuert insbesondere die Frequenz der Lokaloszillatoren der Empfangsteile 10, 12. Sie wertet die aus der NF-Stufe 16 und aus der Qualitätsbewertungsschaltung 18 gewonnenen Qualitätsbewertungsinformationen aus. Weiterhin empfängt die Steuerschaltung 20 aus einem RDS-Decoder 22 die aus dem RDS-Datenstrom gewonnenen Informationen über verfügbare Alternativfrequenzen zu dem Sender, auf den das Empfangsteil 10 eingestellt ist.

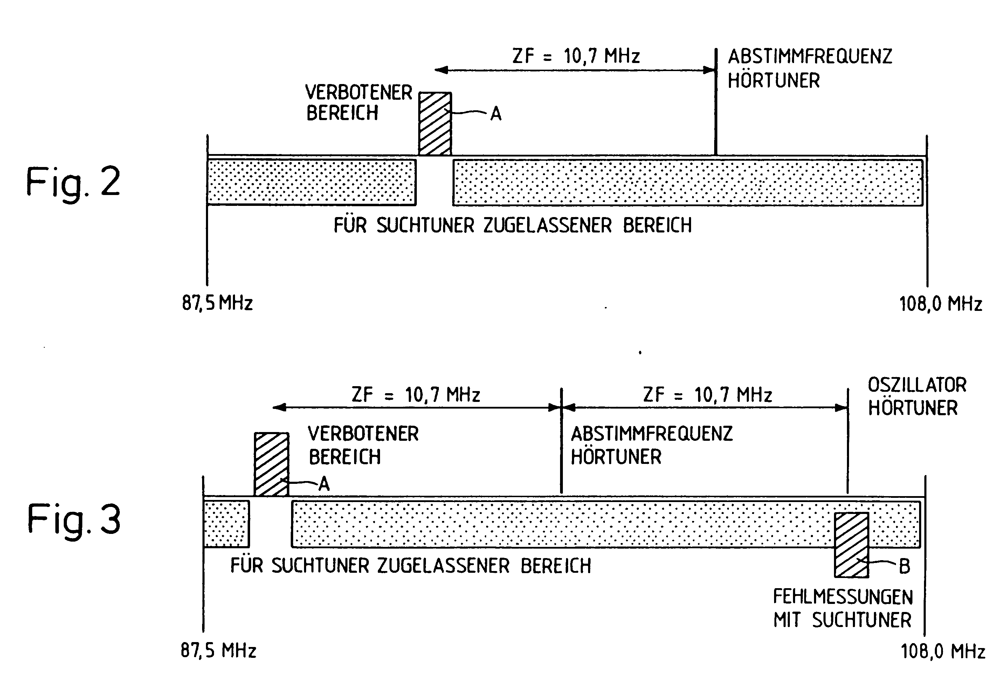

Der in den Figuren 2 und 3 gezeigte Empfangsbereich der beiden Empfangsteile des Rundfunkempfängers erstreckt sich im UKW-Band von 87,5 bis 108,0 MHz. Gemäß dem erfindungsgemäßen Verfahren wird in einem Abstand unterhalb der Abstimmfrequenz des Hörempfängers 10, der gleich der Zwischenfrequenz ist, mit welcher dieser Empfänger arbeitet, also üblicherweise 10,7 MHz, ein verbotener Bereich von vorbestimmter Breite definiert. Dieser verbotene Bereich ist in Fig. 2 und in Fig. 3 schraffiert dargestellt und mit A bezeichnet. Der verbotene Bereich A hat eine Breite von einigen 100 Kilohertz und entspricht in etwa der Breite des ZF-Durchlaßbandes des Hörempfängers 10. Während der Hörempfänger 10 auf einen bestimmten Sender eingestellt ist, werden die vom RDS-Decoder 22 gelieferten Informationen über Alternativfrequenzen zu diesem Sender durch die Steuerschaltung 20 ausgewertet, die den Suchempfänger 12 durch Steuerung der Frequenz seines Lokaloszillators nacheinander auf diese Alternativfrequenzen abstimmt, um die sich für die verschiedenen Alternativfrequenzen ergebende Empfangsqualität zu ermitteln. Vor der Abstimmung auf jede der Alternativfrequenzen prüft aber die Steuerschaltung 20, ob sie in den verbotenen Bereich A fallen würde. Falls eine Alternativfrequenz in den verbotenen Bereich A fällt, erfolgt keine Abstimmung des Suchempfängers auf diese Frequenz. Bei einer Abstimmung des Suchempfängers auf eine Frequenz innerhalb des verbotenen Bereiches A würden aufgrund von unvermeidlichen Abstrahlungen und Verkopplungen im Inneren des Rundfunkempfängers Störungen des Hörempfängers 10 auftreten.

Die Funktion des Suchempfängers 12 kann ihrerseits durch Einstrahlung aus dem Lokaloszillator des Hörempfängers 10 gestört werden, wenn die Alternativfrequenz, auf die der Suchempfänger 12 abgestimmt ist, in den Bereich der aktuellen Oszillatorfrequenz des Hörempfängers 10 gelangt. Daher wird, wie in Fig. 3 dargestellt, ferner ein zweiter verbotener Bereich definiert, der mit B bezeichnet und schraffiert dargestellt ist. Er liegt in einem Abstand von der Abstimmfrequenz des Hörempfängers 10, der gleich der Zwischenfrequenz ist, also im Normalfall 10,7 MHz beträgt, und hat etwa die gleiche Breite wie der verbotene Bereich A. Bevor also der Suchempfänger 12 auf eine Alternativfrequenz abgestimmt wird, wird geprüft, ob diese in den verbotenen Bereich B fallen würde. Wenn dies zutrifft, erfolgt keine Abstimmung des Suchempfängers 12 auf diese Frequenz. Auf diese Weise wird vermieden, daß Empfangsstörungen des Suchempfängers zu einer unzutreffenden Qualitätsbewertung bestimmter Alternativfrequenzen führen.

Um trotz der Definition von verbotenen Bereichen alle dem RDS-Datenstrom entnommenen Alternativfrequenzen überprüfen zu können, wird der Hörempfänger 10, sobald der Suchempfänger 12 eine Alternativfrequenz prüfen soll, die in einen verbotenen Bereich fallen würde, zumindest vorübergehend auf eine der verfügbaren Alternativfrequenzen abgestimmt, vorzugsweise diejenige, welche die bestmögliche Empfangsqualität bietet.

Beide Empfangsteile 10 und 12 sind in Einfach-Superheterodyntechnik ausgebildet und arbeiten mit der üblichen Zwischenfrequenz von 10,7 MHz.

## Patentansprüche

1. Verfahren zur Abstimmung eines Rundfunkempfängers, der zwei Superhet-Empfangsteile (10, 12) aufweist, von denen das erste Empfangsteil (10) die von dem eingestellten Sender empfangenen Signale für die Wiedergabe über Schallwandler aufbereitet und das zweite Empfangsteil (12) zumindest bei Bedarf auf Alternativfrequenzen abgestimmt wird,
- wobei vor Abstimmung des zweiten Empfangsteils (12) auf eine Alternativfrequenz geprüft wird, ob die für diese Alternativfrequenz erforderliche Oszillatorfrequenz des zweiten Empfangsteils (12) in ein auf die Frequenz des eingestellten Senders zentriertes Frequenzband von vorbestimmter Breite fällt, und
- jede Alternativfrequenz mit einer in dieses Frequenzband fallenden Oszillatorfrequenz bei der Abstimmung des zweiten Empfangsteils (12) übergangen wird,
dadurch gekennzeichnet, daß
- das zweite Empfangsteil (12) auf verfügbare Alternativfrequenzen zu dem eingestellten Sender abgestimmt wird,
- die sich bei den Alternativfrequenzen ergebende Empfangsqualität bewertet wird und
- vor der Abstimmung des zweiten Empfangsteils (12) auf eine Alternativfrequenz weiterhin geprüft wird, ob diese Alternativfrequenz in ein auf die aktuelle Oszillatorfrequenz des ersten Empfangsteils (10) zentriertes Frequenzband (B) von vorbestimmter Breite fällt, und
- vor der Prüfung der Empfangsqualität einer Alternativfrequenz, die in dieses Frequenzband (B) fällt, das erste Empfangsteil (10) zumindest vorübergehend auf eine der Alternativfrequenzen abgestimmt wird.

2. Verfahren zur Abstimmung eines Rundfunkempfängers, der zwei Superhet-Empfangsteile (10, 12) aufweist, von denen das erste Empfangsteil (10) die von dem eingestellten Sender empfangenen Signale für die Wiedergabe über Schallwandler aufbereitet und das zweite Empfangsteil (12) zumindest bei Bedarf auf Alternativ frequenzen abgestimmt wird,
- wobei vor Abstimmung des zweiten Empfangsteils (12) auf eine Alternativfrequenz geprüft wird, ob die für diese Alternativfrequenz erforderliche Oszillatorfrequenz des zweiten Empfangsteils (12) in ein auf die Frequenz des eingestellten Senders zentriertes Frequenzband von vorbestimmter Breite fällt, und
- jede Alternativfrequenz mit einer in dieses Frequenzband fallenden Oszillatorfrequenz bei der Abstimmung des zweiten Empfangsteils (12) übergangen wird,
dadurch gekennzeichnet, daß
- das zweite Empfangsteil (12) auf verfügbare Alternativfrequenzen zu dem eingestellten Sender abgestimmt wird,
- die sich bei den Alternativfrequenzen ergebende Empfangsqualität bewertet wird und
- vor der Abstimmung des zweiten Empfangsteils (12) auf eine Alternativfrequenz geprüft wird, ob diese Alternativfrequenz in das auf die aktuelle Oszillatorfrequenz des ersten Empfangsteils (10) zentrierte Frequenzband (B) von vorbestimmter Breite fällt, und
- jede in dieses Frequenzband (B) fallende Alternativfrequenz bei der Abstimmung des zweiten Empfangsteils (12) übergangen wird
- oder die für diese Alternativfrequenz erhaltene Qualitätsbewertung nicht berücksichtigt wird.

3. Verfahren nach einem der vorstehenden Ansprüche, dadurch gekennzeichnet, daß die Alternativfrequenzen aus dem RDS-Datenstrom abgeleitet werden und das zweite Empfangsteil (12) nur auf Frequenzwerte abgestimmt wird, die mit einer der Alternativfrequenzen übereinstimmen.

## Claims

1. A method for tuning a radio receiver comprising two heterodyne receive sections (10, 12), the first receive section (10) of which conditions the signals received from the tuned-in station for the reproduction via sound converters and the second receive section (12) of which is tuned at least if necessary to alternative frequencies,
- whereby before tuning the second receive section (12) to an alternative frequency a check is made to establish whether the oscillator frequency of the second receive section (12) required for this alternative frequency falls into a frequency band of predetermined width which is centred on the frequency of the tuned-in station, and
- each alternative frequency having an oscillator frequency falling into this frequency band is skipped during the tuning of the second receive section (12),
**characterised in that**
- the second receive section (12) is tuned to available alternative frequencies for the tuned-in station,
- the reception quality resulting with the alternative frequencies is evaluated and
- before tuning the second receive section (12) to an alternative frequency, a check is moreover made to establish whether this alternative frequency falls into a frequency band (B) of predetermined width which is centred on the current oscillator frequency of the first receive section (10), and
- before checking the reception quality of an alternative frequency falling into this frequency band (B), the first receive section (10) is tuned at least temporarily to one of the alternative frequencies.

2. A method for tuning a radio receiver comprising two heterodyne receive sections (10, 12), the first receive section (10) of which conditions the signals obtained from the tuned-in station for the reproduction via sound converters and the second receive section (12) is tuned at least if necessary to alternative frequencies,
- whereby before tuning the second receive section (12) to an alternative freqeuncy a check is made to establish whether the oscillator frequency of the second receive section (12) required for this alternative frequency falls into a frequency band of predetermined width which is centred on the frequency of the tuned-in station and
- each alternative frequency having an oscillator frequency falling into this frequency band is skipped during the tuning of the second receive section (12),
**characterised in that**
- the second receive section (12) is tuned to available alternative frequencies for the tuned-in station,
- the reception quality produced with the alternative frequencies is evaluated and
- before tuning the second receive section (12) to an alternative frequency a check is made to establish whether this alternative frequency falls into the frequency band (B) of predetermined width which is centred on the current oscillator frequency of the first receive section (10), and
- each alternative frequency falling into this frequency band (B) is skipped during the tuning of the second receive section (12)
- or the quality assessment obtained for this alternative frequency is not taken into consideration.

3. A method according to one of the preceding Claims,
**characterised in that** the alternative frequencies are derived from the RDS data stream and the second receive section (12) is only tuned to frequency values which tally with one of the alternative frequencies.

## Revendications

1. Procédé pour accorder un récepteur radio qui présente deux étages récepteurs (10, 12) superhétérodynes dont le premier étage récepteur (10) conditionne les signaux reçus par la station sur laquelle il a été accordé pour la reproduction par transducteurs acoustiques et le second étage récepteur (12) est accordé, au moins en cas de besoin, sur des fréquences alternatives, dans lequel
- on vérifie, avant de procéder à l'accord du second étage récepteur (12) sur une fréquence alternative, si la fréquence oscillatoire du second étage récepteur (12), nécessaire à cette fréquence alternative, tombe dans une bande de fréquence de largeur prédéterminée centrée sur la fréquence de la station choisie et
- chaque fréquence alternative ayant une fréquence oscillatoire tombant dans cette bande de fréquence est évitée lorsqu'on accorde le second étage récepteur (12),
caractérisé en ce que
- le second étage récepteur (12) est accordé sur des fréquences alternatives par rapport à la station choisie,
- la qualité de réception résultant des fréquences alternatives est évaluée, et
- avant l'accord du second étage récepteur (12) sur une fréquence alternative, il est encore vérifié si cette fréquence alternative tombe dans une bande de fréquence (B) de largeur prédéterminée, centrée sur la fréquence oscillatoire actuelle du premier étage récepteur (10), et
- avant la vérification de la qualité de réception d'une fréquence alternative, qui tombe dans cette bande de fréquence (B), le premier étage récepteur (10) est accordé au moins provisoirement sur une dedites fréquences alternatives.

2. Procédé pour accorder un récepteur radio qui présente deux étages récepteurs (10, 12) superhétérodynes dont le premier étage récepteur (10) conditionne les signaux reçus par la station sur laquelle il a été accordé pour la reproduction par transducteurs acoustiques et le second étage récepteur (12) est accordé, au moins en cas de besoin, sur des fréquences alternatives, dans lequel
- on vérifie, avant de procéder à l'accord du second étage récepteur (12) sur une fréquence alternative, si la fréquence oscillatoire du second étage récepteur (12), nécessaire à cette fréquence alternative, tombe dans une bande de fréquence de largeur prédéterminée centrée sur la fréquence de la station choisie et
- chaque fréquence alternative ayant une fréquence oscillatoire tombant dans cette bande de fréquence est évitée lorsqu'on accorde le second étage récepteur (12),
caractérisé en ce que
- le second étage récepteur (12) est accordé sur des fréquences alternatives par rapport à la station choisie,
- la qualité de réception résultant des fréquences alternatives est évaluée et
- avant l'accord du second étage récepteur (12) sur une fréquence alternative, il est encore vérifié si cette fréquence alternative tombe dans une bande de fréquence (B) de largeur prédéterminée, centrée sur la fréquence oscillatoire actuelle du premier étage récepteur (10), et
- chaque fréquence alternative tombant dans cette bande de fréquence (B) est évitée lors de l'accord du second étage récepteur (12)
- ou l'évaluation de qualité obtenue pour cette fréquence alternative n'est pas prise en compte.

3. Procédé selon l'une quelconque des revendications précédentes, caractérisé en ce que les fréquences alternatives sont dérivées du flux de données RDS et en ce que le second étage récepteur (12) n'est accordé que sur des valeurs de fréquence qui coïncident avec une desdites fréquences alternatives.
